Europäisches Patentamt

European Patent Office

Office européen des brevets

(19)

(11) Publication number: **0 366 013**

**A2**

(12) **EUROPEAN PATENT APPLICATION**

(21) Application number: **89119494.6**

(22) Date of filing: **20.10.89**

(51) Int. Cl.⁵: **H01L 21/311 , H01L 21/316**

(30) Priority: **27.10.88 US 263563**

(43) Date of publication of application:
**02.05.90 Bulletin 90/18**

(84) Designated Contracting States:
**DE FR GB IT NL**

(71) Applicant: **TEXAS INSTRUMENTS INCORPORATED**
**13500 North Central Expressway**
**Dallas Texas 75265(US)**

(72) Inventor: **Frederick, Gene R.**
**1515 Summit**
**Mesquite Texas 75149(US)**
Inventor: **Webb, Douglas A.**
**904 Asby Drive**
**Allen Texas 75002(US)**
Inventor: **Lane, Andrew P.**
**Route 2, Box 699**
**Westminster Texas 75069(US)**
Inventor: **Camp, Janet P.**
**2001 Aliso**
**Plano Texas 75074(US)**

(74) Representative: **Leiser, Gottfried, Dipl.-Ing. et al**
**Patentanwälte Prinz, Leiser, Bunke & Partner**
**Manzingerweg 7**
**D-8000 München 60(DE)**

(54) **Selective dielectric deposition on horizontal features of an integrated circuit subassembly.**

(57) A wafer having an integrated circuit subassembly (26) is provided having a first trench (28) and second trench (30). The first trench (28) includes angled non-vertical surfaces (34). The second trench (30) includes vertical surfaces (38) and lower non-vertical surface (40). A dielectric layer (22) is deposited along surfaces of subassembly 26, and then etched such that only layers 22 overlying non-vertical surfaces remain.

EP 0 366 013 A2

FIG. 1a    FIG. 1b    FIG. 1c

# SELECTIVE DIELECTRIC DEPOSITION ON HORIZONTAL FEATURES OF AN INTEGRATED CIRCUIT SUB-ASSEMBLY

## TECHNICAL FIELD OF THE INVENTION

This invention pertains in general to integrated circuit fabrication, and more particularly to a structure and method for selectively depositing a dielectric material on non-vertical surfaces of an integrated circuit subassembly.

## BACKGROUND OF THE INVENTION

Selective deposition of dielectric materials on integrated circuit wafers is commonly used in a variety of applications. For example, oxide or nitride masks are used to shield selected portions of photosensitive materials during photographic semiconductor Masking may further be used to allow the introduction of dopants into selected semiconductor regions within the integrated circuit, while preventing the doping of those regions covered by the dielectric. Dielectrics also serve as a good masks against impurities, and may therefore be used to selectively protect the semiconductor surface from contaminants. The need for accurate masking processes is constantly increasing as the complexity of semiconductor devices moves forward.

Due to the high dielectric constant of an oxide, oxide may also be used to form an excellent capacitor. Again, circuit design may require selective deposition of the oxide to obtain the necessary capacitor configuration.

Trenches, or wells, are often cut within a semiconductor wafer to isolate devices constructed thereon. Quite often, dielectric material is deposited within these trenches. Due to circuit design requirements, there is often a need to selectively deposit the dielectric only along the bottom of the trench and not on the sidewalls thereof. Such deposition of a dielectric within a trench of narrow width often creates void formations therein. As a result, complex etching processes are necessary to selectively remove the dielectric such that the void is corrected while the desired deposition results.

A need has thus arisen for an improved and simplified process for depositing a dielectric material on selected surfaces of an integrated circuit wafer.

## SUMMARY OF THE INVENTION

In accordance with the present invention, an improved process is provided which permits selective deposition of a dielectric material on non-vertical surfaces of a wafer having an integrated circuit (IC) component subassembly.

In accordance with the present invention, a process for differential deposition of a silicon-containing dielectric includes disposing a wafer in a reactor. An organosilicon compound and gaseous compound containing nitrogen are introduced into the reactor, thereby forming a silicon-containing dielectric. The dielectric forms along both vertical and non-vertical surfaces of the wafer. The wafer is then exposed to an etchant. The etchant differentially removes the silicon-containing dielectric at a faster rate along the vertical surfaces than the non-vertical surfaces.

An important aspect of the present invention thus includes disposing a dielectric layer of varying susceptibility to an etchant along an IC component. Susceptibility of the dielectric layer varies in accordance with the incline of its underlying support structure. Dielectric layers overlying vertical surfaces are more vulnerable to a dielectric etchant, as compared to layers overlying non-vertical surfaces. As a result, exposure to an etchant will differentially remove the dielectric in areas being more susceptible thereto. Thus, the present invention provides the technical advantage of selective deposition of a dielectric layer solely along non-vertical surfaces. The present invention may, for example, be used in the deposition of dielectric material within trenches without forming voids.

More particularly, the present invention includes various alternative organosilicon and gaseous nitrogen compounds. Different organosilicon compounds include tetraethoxysilane (TEOS), tetramethylcyclotetrasiloxane (TMCTS) and organosilazanes. Alternative gaseous compounds containing nitrogen include nitrogen trifluoride ($NF_3$) and nitrous oxide ($N_2O$).

BRIEF DESCRIPTION OF THE DRAWINGS

Further features and advantages will become more apparent from the following and more particular description of the preferred embodiment of the invention, as illustrated in the accompanying drawings, in which like reference characters generally refer to the same parts or functions throughout the views, and in which:

FIGURE 1a is a highly magnified schematic sectional view of a semiconductor wafer showing horizontal and vertical edges therein;

FIGURE 1b is a sectional view of the structure of FIGURE 1a after a silicon-containing compound layer has been deposited thereon;

FIGURE 1c is a sectional view of the structure of FIGURE 1b following exposure of the device to an etchant;

FIGURE 2a is a highly magnified schematic sectional view of a second semiconductor wafer having various vertical and non-vertical surfaces;

FIGURE 2b is a sectional view of the structure of FIGURE 2a having a silicon-containing compound layer disposed thereon; and

FIGURE 2c is a sectional view of the structure of FIGURE 2b following exposure to an etchant capable of removing a silicon-containing compound.

DETAILED DESCRIPTION OF THE INVENTION

FIGURE 1a illustrates a cross-sectional view of a typical integrated circuit (IC) component 10 included within a semiconductor wafer 11. In the place of a semiconductor material, wafer 11 may have a metallic or dielectric upper surface. The process of the present invention applies to any surface on which a differential formation of a silicon-containing dielectric layer is desired.

During semiconductor fabrication processes, it is common for wafer 11 to have a trench 12 formed in the semiconductor surface. As a result, there are defined vertical surfaces 14, a lower non-vertical surface 16, and upper non-vertical surfaces 18. Vertical surfaces 14 may be perpendicular to the base 20 of IC component 10, or may be at an angle with respect thereto.

The wafers 11 used to demonstrate the invention disclosed herein were patterned with an array of trenches 12. Each array consisted of six trenches having widths varying from 0.8 to 5.0 microns. The depth of trenches 12 ranged from 2.2 microns for the smallest trench 12, to 2.6 microns for the largest trench 12.

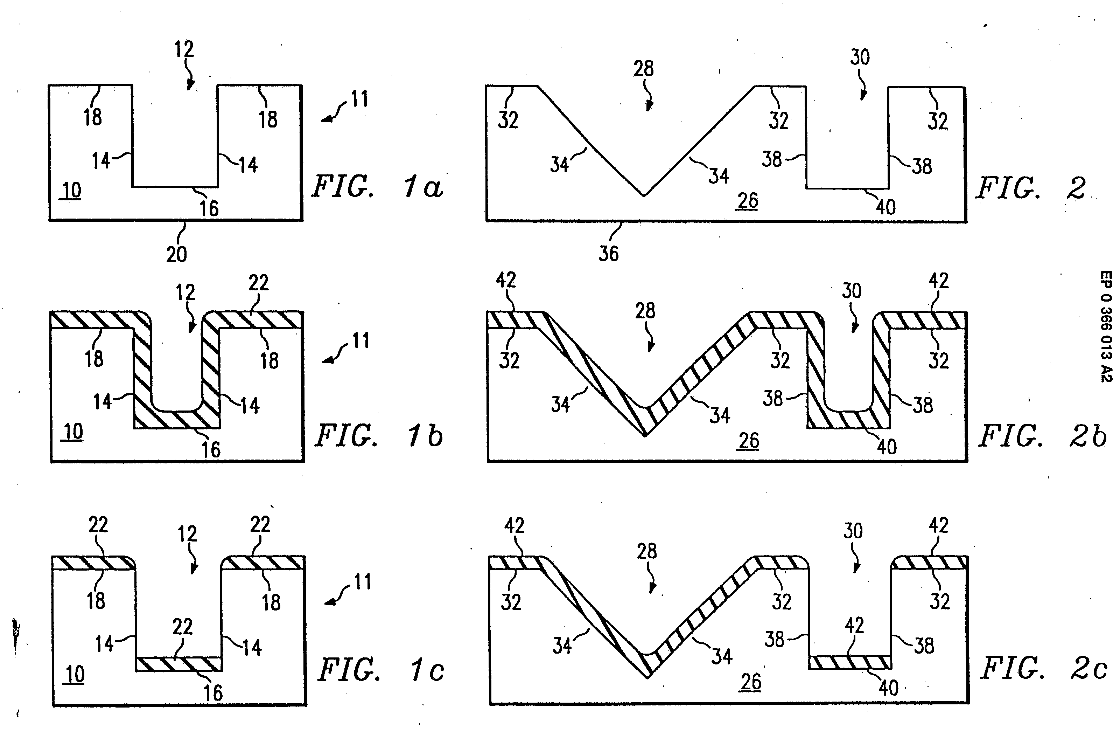

FIGURE 1b illustrates a cross-sectional view of wafer 11 of FIGURE 1a following the deposition of a dielectric layer 22. Dielectric layer 22 is typically formed by deposition of a silicon-containing compound such as silicon dioxide ($SiO_2$). However, it is to be understood that numerous alternative silicon-containing compounds may be substituted and used for forming dielectric layer 22. Deposition of $SiO_2$ may be carried out in a plasma-enhanced chemical vapor deposition (PECVD) reactor having a parallel plate design. Energy sources for the plasma may include alternating current at radio or microwave frenquencies, and may include magnetic enhancement. Dielectric layer 22 is deposited by introducing an organosilicon compound and a gaseous compound containing nitrogen into the reactor. More specifically, tetraethoxysilane (TEOS) may be used as an organosilicon compound, while nitrogen trifluoride ($NF_3$) may be used as the gaseous compound containing nitrogen. The period for allowing deposition may be, for example, thirty seconds, with the flow rate for the introduction of $NF_3$ set at 20 sccm. The TEOS flow rate is difficult to monitor without impeding the process, but may be approximated at 10 sccm. However, the reaction of the organosilicon compound TEOS with the $NF_3$ should occur regardless of the TEOS flow rate. Variance in the TEOS flow rate will only affect the time necessary to deposit a desired thickness of dielectric layer 22.

The process within the PECVD reactor may be carried out at a relatively low pressure of 0.6 torr. The electrode temperature may comprise 70° C, while the substrate temperature may be 350° C. The temperature of the TEOS introduced into the reactor may be about 50° C, with the power supplied within the reactor being about 60 watts.

The thickness of deposited dielectric layer 22 may be measured using a film thickness analyzer, with the average value thereof being 3820 angstroms. It should be noted, however, that as the width of trench 12 decreases, dielectric layer 22 along lower non-vertical surface 16 will decrease relative to the thickness of layer 22 at upper non-vertical surfaces 18. This is a result of the fact that upper non-vertical surfaces 18 shade trench 12 from the deposition process. As the width of trench 12 decreases, the shading becomes more prominent, and as a result less exposure of lower non-vertical surface 16 occurs. Consequently, dielectric layer 22 may be thinner along lower non-vertical surface 16 within trench 12.

FIGURE 1c illustrates a cross-sectional view of wafer 11 following an etching stage. After the deposition stage, wafer 11 may be cleaved (for observation purposes) and then exposed to an etchant. A 10% hydrofluoric acid solution may be used as the etchant in this process. However, it is to be understood that hydrogenfluoride (HF) alone, in an anhydrous state would equally serve as an etchant in the present invention. The etch may be effected in a simple HF wash. Alternatively, wafer 11 containing IC component 10 may be placed in a fumer, along with the introduction of HF gas and water vapor to carry out the etching process.

Samples of IC component 10 have been etched in HF for 1, 5, 10, 15 and 25 seconds. A scanning electron microscope may be used to examine these samples. Table I below gives dielectric layer 22 thicknesses along the lower non-vertical surface 16, upper non-vertical surfaces 18 and vertical surfaces 14. These dimensions were measured from scanning electron microscope photographs.

TABLE I

| HF Etch time sec. | Large Trench (12) Dielectric layer (22) thickness on surfaces* | | | Small Trench (12) Dielectric layer (22) thickness on surfaces* | | |
|---|---|---|---|---|---|---|
| | (18) | (16) | (14) | (18) | (16) | (14) |
| 1 | 4,000 | 4,000 | 2,000 | 4,000 | 3,300 | 1,500 |
| 5 | 3,700 | 3,700 | 1,700 | 3,700 | 3,000 | 1,200 |
| 10 | 3,600 | 3,600 | 500 | 3,600 | 3,000 | 500 |
| 15 | 3,600 | 3,600 | 0 | 3,600 | 2,800 | 0 |
| 25 | 3,000 | 3,000 | 0 | 3,000 | 2,400 | 0 |

* All thicknesses measured in angstroms.

As Table I reflects, after a one second HF etch, dielectric layer 22 was still attached to vertical surface 14. A small indentation was observed at upper non-vertical surface 18 of trench 12. After a five second etch, dielectric layer 22 at vertical surfaces 14 appeared very rough. After ten seconds, a majority of dielectric layer 22 at vertical surfaces 14 was removed, and the little remaining was peeling therefrom. After fifteen seconds, wafer 11 appeared as illustrated in FIGURE 1c. While a majority of dielectric layer 22 still existed at upper non-vertical surfaces 18, all of dielectric layer 22 had been removed from vertical surfaces 14. Therefore, the exposure to HF etched wafer 11 differentially along the vertical 14 and non-vertical 16 and 18 surfaces.

It may now be readily appreciated that dielectric layer 22 along vertical surfaces 14 was more susceptible to an etchant than was the same layer 22 along non-vertical surfaces 16 and 18. Thus, the structure illustrated in FIGURE 1b comprises a wafer 11 subassembly having a dielectric layer varying in susceptibility to an etchant therefor. The process and product of the present invention therefore provide for the ultimate selective deposition of dielectric layer 22 solely on non-vertical surfaces 16 and 18.

Similar results have been observed through the use of alternative compounds. Other effective organosilicon compounds include tetramethylcyclotetrasiloxane (TMCTS). Because of the similarity in structure, like results can be expected with other organosilicon compounds containing nitrogen, such as organosilazanes, for the deposition of silicon nitride ($Si_3N_4$) layers. Another effective gaseous compound containing nitrogen is nitrous oxide ($N_2O$).

FIGURE 2a illustrates a cross-sectional view of an alternative embodiment of the present invention. An IC component subassembly 26 includes a first trench 28 and a second trench 30 disposed therein. Subassembly 26 further includes upper non-vertical surfaces 32. Trench 28 includes angled non-vertical surfaces 34. Angled non-vertical surfaces 34 extend downward at an angle of approximately 45° from a vertical line between upper non-vertical surfaces 32 and the base 36 of IC component 26. Second trench 30 has vertical surfaces 38 and a lower non-vertical surface 40.

FIGURE 2b illustrates subassembly 26 of FIGURE 2a following deposition of a dielectric layer 42. Dielectric layer 42 forms along upper non-vertical surfaces 32, and within trenches 28 and 30. Dielectric layer 42 is formed in accordance with the same process described above in reference to FIGURE 1b. Again, an organosilicon compound and gaseous compound containing nitrogen are introduced into a reactor. The compounds react, thereby depositing dielectric layer 42 along the surfaces of subassembly 26. Again, the organosilicon compound may comprise TEOS, TMCTS, or organosilazanes. The gaseous compound containing nitrogen may be $NF_3$ or $N_2O$.

4

FIGURE 2c illustrates IC component 26 after having been exposed to a dielectric etchant in the manner previously described. The dielectric etchant typically comprises HF in either an anhydrous or aqueous state. As shown in FIGURE 2c, dielectric layer 42 is completely removed by the etchant along vertical surfaces 38 of second trench 30. However, dielectric layer 42 remains along angled non-vertical surfaces 34 of trench 28. Further, dielectric layer 42 remains along upper non-vertical surfaces 32 and lower non-vertical surface 40. Thus, the susceptibility of dielectric layer 42 to an etchant therefor is much higher along vertical surfaces 38 than for angled non-vertical surfaces 34 and upper and lower non-vertical surfaces 32 and 40. As a result, the present invention claimed and disclosed herein provides for selective deposition of a dielectric layer 42 on surfaces of a subassembly 26 which are non-vertical 32, 34 and 40. The present invention is thus quite advantageous in selectively forming accurate dielectric layers on specific portions of small IC components.

Although the present invention has been described in detail, it should be understood that various changes substitutions and alterations can be made hereto without departing from the spirit and scope of the invention as defined by the appended claims.

## Claims

1. A process for the differential deposition of a dielectric comprising:
depositing a dielectric layer on a wafer having vertical and non-vertical surfaces, said dielectric comprising a silicon-containing compound selected from a group consisting of oxides and nitrides; and
etching said dielectric layer such that said portion of said dielectric layer over said vertical surfaces are substantially removed but said dielectric layer over said non-vertical surfaces remain.

2. The process of Claim 1 wherein said step of depositing comprises:
introducing an organosilicon compound into a low pressure reactor containing said wafer, and
introducing a gaseous compound containing nitrogen into the reactor.

3. The process of Claim 2 wherein said step of introducing an organosilicon compound comprises introducing tetraethoxysilane into the reactor.

4. The process of Claim 2 wherein said step of introducing an organosilicon compound comprises introducing tetramethylcyclotetrasiloxane into the reactor.

5. The process of Claim 2 wherein said step of introducing an organosilicon compound comprises introducing an organosilazane into the reactor.

6. The process of Claim 2 wherein said step of introducing a gaseous compound containing nitrogen comprises introducing nitrogen trifluoride into the reactor.

7. The process of Claim 2 wherein said step of introducing a gaseous compound containing nitrogen comprises introducing nitrous oxide into the reactor.

8. The process of Claim 2 wherein said reactor comprises a plasma-enhanced chemical vapor deposition reactor.

9. The process of Claim 1 wherein said step of etching comprises the step of differentially etching the silicon-containing compound on the vertical surface at a faster rate than the etching of the silicon-containing compound on the non-vertical surface, thereby forming a silicon-containing compound layer on the non-vertical surface and eliminating substantially all of the silicon-containing compound on the vertical surface.

10. The process of Claim 1 wherein said step of etching the dieletric layer comprises exposing said layer to hydrogen fluoride.

11. The process of Claim 10 wherein said step of etching the dielectric layer comprises exposing said layer to anhydrous hydrogen fluoride.

12. The process of Claim 10 wherein said step of exposing said layer to hydrogen fluoride comprises:
placing the wafer in a fumer;
introducing hydrogen fluoride gas into said fumer; and
introducing a water vapor into said fumer.

13. The process of Claim 1 wherein said step of etching the dielectric layer comprises exposing said layer to aqueous hydrofluoric acid.

14. A product formed by the process of Claim 1.

15. A method for the differential deposition of a dielectric on a semiconductor surface having vertical and non-vertical surfaces, comprising:
depositing a dielectric layer on said surface, said dielectric layer having increased susceptibility to an etchant in dielectric areas overlying vertical surfaces of said semiconductor surface.

16. The method of Claim 15 and further comprising:

applying an etchant to the dielectric layer in order to remove substantially all of the dielectric over said vertical surfaces while leaving dielectric over said non-vertical surfaces of the semiconductor surface.

17. A process for the differential deposition of a silicon-containing compound comprising:

disposing an integrated circuit wafer having vertical and non-vertical surfaces in a low pressure reactor;

introducing an organosilicon compound into the reactor;

introducing a gaseous compound containing nitrogen into the reactor, such that a silicon-containing compound on the vertical and non-vertical surfaces is deposited; and

exposing said integrated circuit component to an etchant.

18. The process of Claim 17 and further comprising:

etching said silicon-containing compound on the vertical surface at a faster rate than the etching of the silicon-containing compound on the non-vertical surface, thereby forming a layer of silicon-containing compound having greater thickness on the non-vertical surface than on the vertical surface.

19. The process of Claim 17 wherein said step of introducing an organosilicon compound comprises introducing tetraethoxysilane into the reactor.

20. The process of Claim 17 wherein said step of introducing an organosilicon compound comprises introducing tetramethylcyclotetrasiloxane into the reactor.

21. The process of Claim 17 wherein said step of introducing an organosilicon compound comprises introducing an organosilazane into the reactor.

22. The process of Claim 17 wherein said step of introducing a gaseous compound containing nitrogen comprises introducing nitrogen trifluoride into the reactor.

23. The process of Claim 17 wherein said step of introducing a gaseous compound containing nitrogen comprises introducing nitrous oxide into the reactor.

24. The process of Claim 17 wherein said step of exposing said wafer to an etchant comprises exposing said wafer to hydrogen fluoride.

25. The process of Claim 17 wherein said low pressure reactor comprises a plasma-enhanced chemical vapor deposition reactor.

26. An integrated circuit subassembly having vertical and non-vertical surfaces, comprising:

a first silicon-containing compound layer on the non-vertical surface; and

a second silicon-containing compound layer on the vertical surface, said second layer being of a higher susceptibility to an etchant than said first layer.

27. The integrated circuit subassembly of Claim 26 wherein said first and second layers comprise oxide.

28. The integrated circuit subassembly of Claim 26 wherein said first and second layers are formed from an organosilicon compound in conjunction with a gaseous compound containing nitrogen.

29. The integrated circuit subassembly of Claim 26 further including a trench having a lower non-vertical surface and vertical surfaces, said first silicon-containing compound layer on said lower non-vertical surface and said second silicon-containing compound of higher susceptibility on said vertical surfaces.

30. The integrated circuit subassembly of Claim 26 wherein said first and second layers comprise nitride.

FIG. 2

FIG. 2b

FIG. 2c

FIG. 1a

FIG. 1b

FIG. 1c